# EUROPEAN PATENT APPLICATION

(11) **EP 1 283 547 A1**
(43) Date of publication of application: **12.02.2003**
(21) Application number: 01890219.7
(22) Date of filing: 31.07.2001
(51) Int. Cl.: H01L 21/56, H01L 23/31

(54) **Packaging process for semiconductor package**

(71) Applicant: United Test Center Inc., Hsin-Chu (TW)
(72) Inventor: Bai, Jin Chuan, Sanchung, Taipei (TW)
(74) Representative: Haffner, Thomas M.

(57) **Abstract**

A packaging process for a semiconductor package is proposed, in which a plurality of conductive elements disposed on a substrate are electrically connected to the substrate and encapsulated by a first encapsulant formed on the substrate. Further, a semiconductor chip having a plurality of bond pads is mounted on a top surface of the first encapsulant and is electrically connected to the substrate through the bond pads being electrically connected to the corresponding conductive elements. Moreover, as the conductive elements have ends thereof coplanarly formed with the top surface of the first encapsulant, quality of the electrical connection between the chip and the conductive elements can be assured. In addition, as the conductive elements for electrically connecting the chip to the substrate are disposed on the substrate, the packaging cost can be reduced and quality of the packaged product can be improved. Finally, on two opposing surfaces of the substrate there are formed a second encapsulant for encapsulating the chip, and a plurality of solder balls, respectively, so as to complete the packaging of the invention.

## Description

### FIELD OF THE INVENTION

The present invention relates to packaging processes for semiconductor packages, and more particularly, to a packaging process for a semiconductor package in which a semiconductor chip is electrically connected to a substrate in a flip-chip manner.

### BACKGROUND OF THE INVENTION

A flip-chip semiconductor package utilizes solder bumps mounted on an active surface of a semiconductor chip instead of conventional bonding wires for electrically connecting the chip to a substrate, which makes the substrate to be reduced in usable area, and accordingly the semiconductor package can be miniaturized in profile.

The fabrication for the flip-chip semiconductor package includes the steps of: 1) implanting a plurality of solder bumps respectively on a plurality of bond pads formed on the active surface of the chip; 2) turning the active surface of the chip downwardly for respectively bonding the solder bumps to bond pads on the substrate, so as to electrically connect the chip to the substrate through the solder bumps; 3) filling a gap between the chip and the substrate with a resin in an under-filling manner for encapsulating the solder bumps; 4) forming an encapsulant on a surface of the substrate having the chip mounted thereon for encapsulating the chip; and 5) implanting a plurality of solder balls on a surface of the substrate opposing the chip-mounting surface for electrically connecting the chip to an external device.

However, the foregoing flip-chip semiconductor package has the following drawbacks in fabrication, first, the expensively-made chip needs to be discarded if incomplete electrical connection occurs between the solder bumps and the chip, which makes the fabrication be cost-ineffective. Moreover, coplanarity is hardly achieved for ends of the solder bumps implanted on the active surface of the chip, which increases the complexity for the implantation in accuracy and further raises the packaging cost. In addition, the under-filling process is performed based on capillarity, which allows the resin to flow throughout the gap between the chip and the substrate, however, voids may be formed in the gap due to incomplete filling of the resin therein, and thus a popcorn effect tends to be generated during a temperature cycle in subsequent processes, which makes quality of the fabricated product degraded.

### SUMMARY OF THE INVENTION

A primary objective of the present invention is to provide a packaging process for a semiconductor package for improving the production yield and reducing the packaging cost, as well as preventing a popcorn effect from occurrence.

In accordance with the foregoing and other objectives of the invention, a packaging process for a semiconductor package is proposed, which includes the steps of: preparing a substrate having a first surface and a second surface, while a chip-mounting area is formed on the first surface; disposing a plurality of array-arranged conductive elements on the chip-mounting area, while the conductive elements are electrically connected to the substrate; forming a first encapsulant on the chip-mounting area of the substrate for encapsulating the conductive elements, while the conductive elements have ends thereof coplanarly formed with a top surface of the first encapsulant and exposed to the outside of the first encapsulant; providing a semiconductor chip having a first surface and a second surface, while the first surface of the chip is attached to the top surface of the first encapsulant for electrically connecting a plurality of bond pads formed on the first surface of the chip to the ends of the conductive elements respectively; forming a second encapsulant on the first surface of the substrate for encapsulating the chip; and implanting a plurality of array-arranged solder balls on the second surface of the substrate for electrically connecting the chip to an external device through the solder balls.

The conductive elements made of a electrically conductive metal such as tin, lead or tin/lead alloy are disposed on the chip-mounting area of the substrate by means of a conventional printing or implanting technique. With the use of the printing technique, the conductive elements have the ends thereof flatly formed, in which the first encapsulant is identical in thickness to the height of the conductive elements so as to form a coplane between the top surface of the first encapsulant and the ends of the conductive elements, while the ends are exposed to the outside of the first encapsulant. Moreover, a conventional polishing process is performed for simultaneously reducing the thickness of the first encapsulant and the height of the conductive elements to a predetermined value, so as to further miniaturize the semiconductor package in profile. With the use of the implanting technique for disposing the conductive elements on the substrate, after the formation of the first encapsulant, the thickness of the first encapsulant and the height of the conductive elements are synchronously reduced to a predetermined value by means of the polishing process. In this case, the conductive elements have the ends thereof coplanarly formed with the top surface of the first encapsulant, while the ends are exposed to the outside of the first encapsulant.

### BRIEF DESCRIPTION OF THE DRAWINGS

The invention can be more fully understood by reading the following detailed description of the preferred embodiments, with reference made to the accompanying drawings, wherein:
FIGs. 1A-1F are sectional diagrams showing the steps of the packaging process for the first preferred embodiment of the invention;
FIG. 2 is a sectional view of the semiconductor package fabricated according to the second preferred embodiment of the invention; and
FIG. 3 is a sectional view of the semiconductor package fabricated according to the third preferred embodiment of the invention.

### DETAILED DESCRIPTION OF THE PREFERRED EMBODIMENT

### First Preferred Embodiment

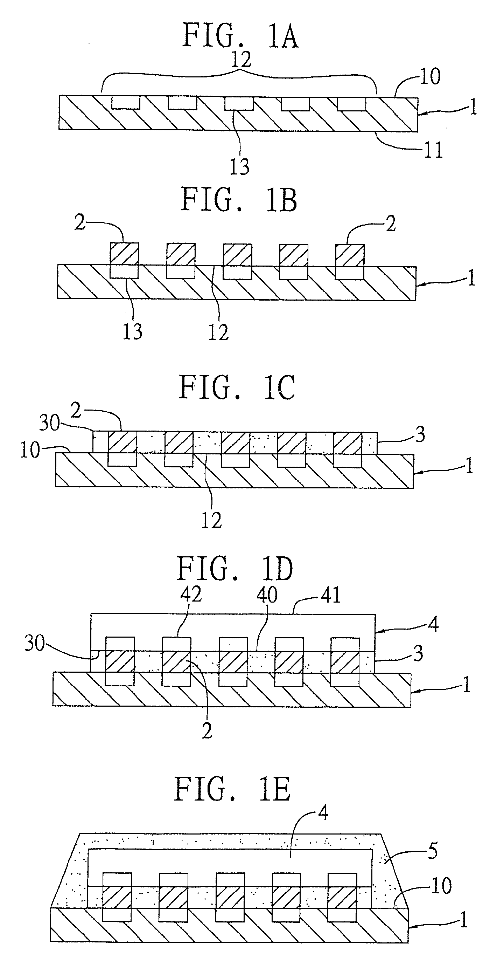

Illustrated in FIGs. 1A-1F are respectively the steps of the packaging process for the first preferred embodiment of the invention.

Referring to FIG. 1A, first, a substrate 1 having a first surface 10 and a second surface 11 is prepared. On an approximately central position of the first surface 10, there is formed a chip-mounting area 12 for disposing a plurality of array-arranged bond pads 13 therein, while the bond pads 13 are electrically connected to the substrate 1. The substrate 1 can be formed as two layers with a plurality of conductive traces (not shown) being mounted on the first surface 10 and the second surface 11 respectively, in which the electrical connection between the bond pads 13 and the substrate 1 is accomplished by respectively connecting the bond pads 13 to the corresponding conductive traces on the substrate 1. Further, in the substrate 1 there are formed a plurality of vias (not shown) penetrating the substrate 1 for electrically connecting the conductive traces on the first surface 10 to those on the second surface 11.

Referring further to FIG. 1B, a plurality of array-arranged conductive bumps 2 are disposed on the chip-mounting area 12 of the substrate 1 by means of a conventional screen-printing process. The conductive bumps 2 are then electrically connected to the bond pads 13 on the chip-mounting area 12 and each formed with a flat end 20 after being disposed on the substrate 1. The conductive bumps 2 can be made of a electrically conductive metal such as tin, lead or tin/lead alloy.

As illustrated in FIG. 1C, after disposing the conductive bumps 2 on the substrate 1, a first encapsulant 3 is formed on the chip-mounting area 12 of the substrate 1 by means of a conventional screen-printing or glob-top process, so as to encapsulate the conductive bumps 2 with no voids formed therein. After the first encapsulant 3 is cured, a top surface 30 thereof is flatly and coplanarly formed with the ends 20 of the conductive bumps 2, while the ends 20 are exposed to the outside of the first encapsulant 3. With the use of such an advanced printing process, the conductive bumps 2 and the first encapsulant 3 provided on the substrate 1 can be precisely made in a desired thickness, which is much smaller than the height of solder bumps used in a conventional flip-chip semiconductor package, so that the semiconductor package fabricated by the packaging process of the invention is effectively miniaturized in profile. Further due to the accuracy of the printing process, the conductive bumps 2 and the first encapsulant 3 can be precisely formed at predetermined positions on the chip-mounting area 12 of the substrate 1 with no occurrence of dislocation. The first encapsulant 3 can be made of a general molding compound such as epoxy resin.

Then, as illustrated in FIG. 1D, a semiconductor chip 4 having a first surface 40 and a second surface 41 is provided, while a plurality of array-arranged bond pads 42 are formed on the first surface 40. The chip 4 then has the first surface 40 thereof attached to the top surface 30 of the first encapsulant 3 for electrically connecting the chip 4 to the substrate 1 through the conductive bumps 2 in a manner that the bond pads 42 are bonded to the ends 20 of the conductive bumps 2. As the top surface 30 of the first encapsulant 3 is coplanarly formed with the ends 20 of the conductive bumps 2, the bond pads 42 of the chip 4 can be effectively electrically connected to the conductive bumps 2, making the fabricated product assured in quality and reliability with no occurrence of the incomplete electrical connection. Furthermore, as the conductive bumps 2 are disposed on the substrate 1 having a much lower fabricating cost than that of the chip 4, it is more cost-effective to discard the substrate 1 when the incomplete electrical connection accomplished by the conductive bumps 2 occurs between the chip 4 and the substrate 1, and thus the packaging cost can be more effectively saved.

Referring to FIG. 1E, after completing the electrical connection between the chip 4 and the substrate 1, a second encapsulant 5 is formed by a conventional molding process on the first surface 10 of the substrate 1 for hermetically encapsulating the chip 4. The second encapsulant 5 is made of a conventional molding compound such as epoxy resin.

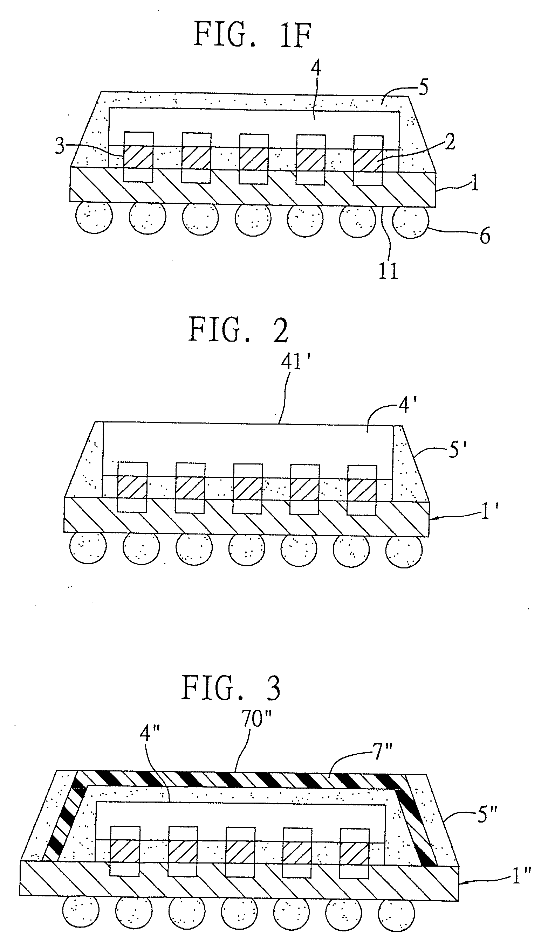

Finally, referring to FIG. 1F, a plurality of array-arranged solder balls 6 are implanted on the second surface 11 of the substrate 1 and electrically connected to the conductive traces (not shown) on the second surface 11, for electrically connecting the chip 4 to an external device such as a printed circuit board, so as to complete the packaging process of the invention.

### Second Preferred Embodiment

Illustrated in FIG. 2 is the semiconductor package fabricated according to the second preferred embodiment of the invention. The packaging process for the second embodiment differs from the foregoing first embodiment in that the semiconductor chip 4' has the second surface 41' thereof exposed to the outside of the second encapsulant 5', which makes the fabricated semiconductor package further reduced in height as well as the heat dissipating efficiency improved due to the exposed surface 41' of the chip 4'.

### Third Preferred Embodiment

Illustrated in FIG. 3 is the semiconductor package fabricated according to the third preferred embodiment of the invention. The packaging process for the third embodiment differs from the foregoing first embodiment in that, prior to the formation of the second encapsulant 5", on the first surface 10" of the substrate 1" there is mounted a heat sink 7", which is subsequently encapsulated by the second encapsulant 5", while a top surface 70" of the heat sink 7" is exposed to the atmosphere. As a result, the heat dissipating efficiency can be further improved. In addition, the heat sink 7" can be directly attached to the second surface 41" of the chip 4" for further reducing the semiconductor package in height.

The invention has been described using exemplary preferred embodiments. However, it is to be understood that the scope of the invention is not limited to the disclosed embodiments. On the contrary, it is intended to cover various modifications and similar arrangements. The scope of the claims, therefore, should be accorded the broadest interpretation so as to encompass all such modifications and similar arrangements.

## Claims

1. A packaging process for a semiconductor package, comprising the steps of:
1) preparing a substrate having a first surface and a second surface, wherein at least one chip-mounting area is formed on the first surface;
2) disposing a plurality of conductive elements on the chip-mounting area of the substrate, wherein the conductive elements are electrically connected to the substrate and each formed with a flat end;
3) forming a first encapsulant on the chip-mounting area of the substrate for encapsulating the conductive elements, wherein the first encapsulant has a top surface coplanarly formed with the ends of the conductive elements, and the ends of the conductive elements are exposed to the outside of the first encapsulant;
4) mounting at least one semiconductor chip having a plurality of bond pads on top surface of the first encapsulant in a manner that the bond pads face the substrate, wherein the bond pads are electrically connected to the exposed ends of the conductive elements respectively;
5) forming a second encapsulant on the first surface of the substrate for encapsulating the chip; and
6) implanting a plurality of solder balls on the second surface of the substrate, wherein the solder balls are electrically connected the substrate.

2. The packaging process of claim 1, wherein the conductive elements are conductive bumps.

3. The packaging process of claim 2, wherein the conductive bumps are made of tin, lead or tin/lead alloy.

4. The packaging process of claim 1, further comprising a step of polishing the first encapsulant and the conductive elements after the step 3) of forming the first encapsulant.

5. The packaging process of claim 1, wherein the chip-mounting area is formed with a plurality of bond pads thereon for being bonded to the conductive elements, and the bond pads are electrically connected to the substrate.

6. The packaging process of claim 1, wherein the chip has a surface with no bond pads formed thereon encapsulated by the second encapsulant.

7. The packaging process of claim 1, wherein the chip has a surface with no bond pads formed thereon exposed to the outside of the second encapsulant for directly contacting the atmosphere.

8. The packaging process of claim 1, further comprising a step of attaching a heat sink to the first surface of the substrate after the step 4) of mounting the chip on the substrate, allowing the heat sink to be encapsulated by the second encapsulant in the step 5) of forming the second encapsulant.
